(19) Europäisches Patentamt
European Patent Office
Office européen des brevets

(11) Veröffentlichungsnummer: **0 186 099**
**A2**

(12) # EUROPÄISCHE PATENTANMELDUNG

(21) Anmeldenummer: 85116085.3

(22) Anmeldetag: 17.12.85

(51) Int. Cl.[4]: C 08 G 77/40
H 01 L 23/30

(30) Priorität: 27.12.84 DE 3447457

(43) Veröffentlichungstag der Anmeldung: 02.07.86 Patentblatt 86/27

(84) Benannte Vertragsstaaten: AT BE CH DE FR GB IT LI NL

(71) Anmelder: WACKER-CHEMIE GMBH
Prinzregentenstrasse 22
D-8000 München 22(DE)

(72) Erfinder: Müller, Johann
Friedrich-Ebert-Strasse 3
D-8263 Burghausen(DE)

(72) Erfinder: Trieschmann, Christa, Dr. Dipl.-Chem.
Stadtplatz 95/96
D-8263 Burghausen(DE)

(72) Erfinder: Preiner, Gerhard, Dr. Dipl.-Chem.
Karl-Gross-Strasse 17
D-8263 Burghausen(DE)

(54) **Vernetzbare Organopolysiloxane, Verfahren zu ihrer Herstellung und Verwendung dieser Organopolysiloxane.**

(57) Die erfindungsgemäßen Organopolysiloxane sind solche der Formel

$$A_xR_{3-x}SiO(SiR_{2-x}A_xO)_nSiR_{3-x}A_x$$

oder

$$(SiR_{2-x}A_xO)_y,$$

worin R gleiche oder verschiedene, einwertige, gegebenenfalls halogenierte Kohlenwasserstoffreste oder aus Kohlenstoff-, Wasserstoff-, Ethersauerstoff- und Fluoratom(en) aufgebaute, einwertige aliphatische Reste, A gleiche oder verschiedene, SiC-gebundene organische Reste mit einer Carboxylgruppe und einer Carbonylgruppe, an die ein organischer Rest mit mindestens einer endständigen Kohlenstoff-Kohlenstoff-Doppelbindung gebunden ist, n eine ganze Zahl im Wert von mindestens 1, x 0 oder 1 und y eine ganze Zahl im Wert von 3 bis 10 bedeutet, wobei diese Organopolysiloxane mindestens einen Rest A je Molekül enthalten.

Derartige Organopolysiloxane werden vorzugsweise durch Umsetzungen von Organopolysiloxanen der oben angegebenen Formel, wobei jedoch A durch Wasserstoff ersetzt ist, mit z. B. Allylbernsteinsäureanhydrid und anschließende Umsetzung der so erhaltenen Organopolysiloxane, die Carbonsäureanhydridgruppen aufweisen, mit z. B. Hydroxyethylacrylat hergestellt.

Die erfindungsgemäßen und erfindungsgemäß hergestellten Organopolysiloxane sind z. B. durch Ultraviolett-Licht vernetzbar und eignen sich ausgezeichnet zur Herstellung von Überzügen oder zum Einbetten von elektronischen Bauteilen.

EP 0 186 099 A2

0186099

Wacker-Chemie GmbH

München, den 13.11.1984
PAT/Dr.Ru/hu

Wa 8436-S

# Vernetzbare Organopolysiloxane, Verfahren zu ihrer Herstellung und Verwendung dieser Organopolysiloxane.

Aus US 4 290 869 (ausgegeben 22. Sept. 1982, R. Pigeon, Rhône-Poulenc Industries) sind photopolymerisierbare Organopolysiloxanzusammensetzungen mit SiC-gebundenen Acryloxyalkyl- oder Methacryloxyalkylgruppen sowie Mercaptoalkylgruppen bekannt. Gemäß dieser Druckschrift, Spalte 8, Zeilen 36 bis 38, haben derartige Zusammensetzungen in verschlossenen und undurchsichtigen Behältern eine Beständigkeit von etwa 48 Stunden.

Es bestand nun die Aufgabe, vernetzbare Organopolysiloxane bereitzustellen, welche in verschlossenen Behältern unter Ausschluß von Licht, insbsondere Ultraviolett-Licht, mindestens 6 Monate gelagert werden können, vor Beginn ihrer Vernetzung genügend niedrig viskos sein können, um auch in verhältnismäßig enge Zwischenräume eindringen zu können, nicht den beim Endverbraucher für Zweikomponenten-Systeme erforderlichen Dosieraufwand benötigen, in den zu ihrer endgültigen Verarbeitung benutzten Vorrichtungen bei deren Stillstand nicht vernetzen können, was Reinigungsaufwand für diese Vorrichtungen vermindert, unter der Einwirkung von Ultraviolett-Licht und Licht mit einer Wellenlänge von 400 bis 600 nm auch in verhältnismäßig dicker Schicht besonders rasch vernetzen, wobei die Vernetzung durch Luft-Sauerstoff nicht beeinträchtigt wird, und die bei ihrer Vernetzung Produkte, z. B. Überzüge, ergeben, die auf den Unterlagen, auf denen sie erzeugt wurden, besonders gut haften. Diese Aufgabe wird durch die Erfindung gelöst.

Gegenstand der Erfindung sind vernetzbare Organopolysiloxane der Formel

$$A_xR_{3-x}SiO(SiR_{2-x}A_xO)_nSiR_{3-x}A_x$$

oder

$$(SiR_{2-x}A_xO)_y ,$$

worin R gleiche oder verschiedene, einwertige, gegebenenfalls halogenierte Kohlenwasserstoffreste oder aus Kohlenstoff-, Wasserstoff-, Ethersauerstoff- und Fluoratom(en) aufgebaute, einwertige aliphatische Reste, A gleiche oder verschiedene, SiC-gebundene organische Reste mit einer Carboxylgruppe und einer Carbonylgruppe, an die ein organischer Rest mit mindestens einer endständigen Kohlenstoff-Kohlenstoff-Doppelbindung gebunden ist, n eine ganze Zahl im Wert von mindestens 1, x 0 oder 1 und y eine ganze Zahl im Wert von 3 bis 10 bedeutet, wobei diese Organopolysiloxane mindestens einen Rest A je Molekül enthalten.

Beispiele für Kohlenwasserstoffreste R sind Alkylreste mit 1 bis 18 Kohlenstoffatomen je Rest, wie der Methyl-, Ethyl-, n-Propyl-, Isopropyl-, n-Butyl- und sec.-Butylrest sowie Octadecylreste; Cycloalkylreste mit 5 bis 8

Kohlenstoffatomen je Rest, wie der Cyclohexyl- und Cycloheptylrest sowie Methylcyclohexylreste; Reste mit mindestens einer aliphatischen Kohlenstoff-Kohlenstoff-Doppelbindung und 2 bis 18 Kohlenstoffatomen je Rest, wobei diese Reste aus Kohlenstoff- und Wasserstoffatomen als einzigen Atomen aufgebaut sind, wie der Vinyl- und Allylrest; Arylreste mit 6 bis 12 Kohlenstoffatomen je Rest, wie der Phenylrest und Xenylreste; Alkarylreste mit 7 bis 18 Kohlenstoffatomen je Rest, wie Tolylreste; Aralkylreste mit 7 bis 18 Kohlenstoffatomen je Rest, wie der Benzyl- und beta-Phenylethylrest.

Beispiele für halogenierte Kohlenwasserstoffreste R sind der 3-Chlorpropyl- und 3,3,3-Trifluorpropylrest sowie o-, p- und m-Chlorphenylreste. Beispiele für aus Kohlenstoff-, Wasserstoff-, Ethersauerstoff- und Fluoratom(en) aufgebaute, einwertige aliphatische Reste R sind der 1,1,2,2,3,3-Hexafluorpropyloxypropylrest und der 1,1,2,2-Tetrafluorethoxypropylrest. Schon wegen der leichteren Zugänglichkeit sind vorzugsweise mindestens 80 % der Anzahl der Reste R in den oben angegebenen Formeln Methylreste.

Als Reste A sind solche der Formel

$$(H_2C{=}CR^2Y_x)_aR^3X\overset{O}{\overset{\|}{C}}(CR^2_2)_mCR^2(COOH)R^1-$$

oder

$$(H_2C{=}CR^2Y_x)_aR^3X\overset{O}{\overset{\|}{C}}\underset{\underset{R^1-}{|}}{C}R^2(CR^2_2)_{m-1}COOH$$

bevorzugt.

In diesen Formeln bedeutet $R^1$ gleiche oder verschiedene zweiwertige, gegebenenfalls halogenierte Kohlenwasserstoffreste, $R^2$ Wasserstoff oder einwertige, von aliphatischen Kohlenstoff-Kohlenstoff-Mehrfachbindungen freie Kohlenwasserstoffreste mit 1 bis 10 Kohlenstoffatomen je Rest, $R^3$ einen Kohlenwasserstoffrest, der zweiwertig ist, wenn a den Wert 1 hat, dreiwertig ist, wenn a den Wert 2 ha, und vierwertig ist, wenn a den Wert 3 hat, X Sauerstoff, Schwefel oder einen Rest der Formel

$$-NR^2-,$$

wobei $R^2$ die oben dafür angegebene Bedeutung hat, und Y eine Gruppierung der Formel

$$-R^1O-$$

$$-\overset{O}{\overset{\|}{C}}O-$$

$$-R^1NR^2$$

$$-\overset{O}{\overset{\|}{C}}NR^2-$$

$$-\overset{O}{\overset{\|}{C}}S-$$

$$-SR^1-,$$

wobei $R^1$ und $R^2$, jeweils die oben dafür angegebene Bedeutung haben, a 1, 2 oder 3 und m eine ganze Zahl im Wert von 1 bis 6 ist und x hat die oben dafür angegebene Bedeutung.

Beispiele für Reste $R^1$ sind solche der Formel

$-CH_2-$, $-(CH_2)_2-$, $-(CH_2)_3-$, $-CH_2C(CH_3)HCH_2-$, o-, p- und m-$CH_2CH_2C_6H_4-$, wobei der Arylrest halogeniert sein kann. Bevorzugt als Reste $R^1$ sind jedoch lineare, zweiwertige von aliphatischen Kohlenstoff-Kohlenstoff-Doppelbindungen freie, aliphatische Reste, insbesondere der Rest der Formel

$$-(CH_2)_3-.$$

Die $R^2$ können gleich oder verschieden sein. Bevorzugt als $R^2$ ist Wasserstoff. Insbesondere, wenn zwei $R^2$ an ein Kohlenstoffatom gebunden sind, ist bevorzugt, daß mindestens ein $R^2$ Wasserstoff ist. Als Kohlenwasserstoffrest $R^2$ ist der Methylrest bevorzugt.

Die Reste $R^3$ können linear oder verzweigt sein. Beispiele für zweiwertige Reste $R^3$ sind die Reste, die oben als Beispiele für Reste $R^1$ angegeben wurden, soweit sie kein Halogen enthalten. Beispiele für andere Reste $R^3$ sind solche der Formel

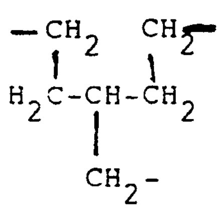

und

$$C(CH_2-)_4.$$

Als X ist Sauerstoff bevorzugt.

Als Y ist die Gruppierung $-\overset{O}{\overset{\|}{C}}O-$ bevorzugt und vorzugsweise hat x als Index von Y den Wert 1.

y ist vorzugsweise 3 oder 4.

Besonders bevorzugt als Reste A sind solche der Formel

$$\left[H_2C{=}C(CH_3)_xH_{1-x}COO\right]_aR^4OOC(CH_2)_2CH(COOH)(CH_2)_3-$$

oder

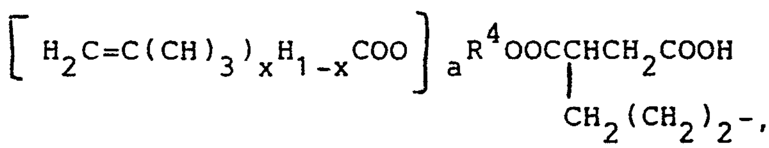

wobei x und a jeweils die oben dafür angegebene Bedeutung haben und $R^4$ je nach dem Wert von a die Formel

$-(CH_2)_3-$, 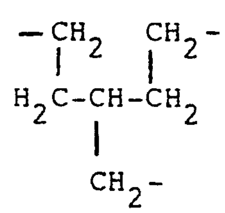

oder

$$C(CH_2-)_4$$

hat. Vorzugsweise hat a jedoch den Wert 1 und x als Index von $CH_3$ ist vorzugsweise 0.

Es kann in jeder Siloxan-Einheit der erfindungsgemäßen, erfindungsgemäß hergestellten oder erfindungsgemäß verwendeten Organopolysiloxanen ein Rest A vorliegen. Vorzugsweise liegt ein Rest A in linearen Organopolysiloxanen jedoch nur in höchstens 10 Molprozent der Siloxaneinheiten dieser Organopolysiloxane vor.

Vorzugsweise haben die erfindungsgemäßen, erfindungsgemäß hergestellten oder erfindungsgemäß verwendeten Organopolysiloxane eine Viskosität von 10 bis 100 000 mPa.s bei 25°C, insbesondere 100 bis 20 000 mPa.s bei 25°C.

Die Organopolysiloxane der Formel

$$A_xR_{3-x}SiO(SiR_{2-x}A_xO)_nSiR_{3-x}A_x$$

können solche der Formel

$$AR_2SiO(SiRAO)_f(SiR_2O)_{n-f}SiR_2A$$

$$R_3SiO(SiRAO)_g(SiR_2O)_{n-g}SiR_3$$

oder

$$AR_2SiO(SiRAO)_f(SiR_2O)_{n-f}SiR_3$$

oder Gemische aus mindestens zwei verschiedenen Arten derartiger Organopolysiloxane sein, wobei R, A und n jeweils die oben dafür angegebene Bedeutung haben, f 0 oder eine ganze Zahl, die höchstens den gleichen Wert wie n hat, und g 1 oder eine andere Zahl im Wert von n - 1 ist.

Gegenstand der Erfindung ist weiterhin ein Verfahren zur Herstellung von vernetzbarem Organopolysiloxanen,dadurch gekennzeichnet, daß
zunächst in einer ersten Stufe Organopolysiloxan der Formel

$$H_xR_{3-x}SiO(SiR_{2-x}H_xO)_nSiR_{3-x}H$$

oder

$$(SiR_{2-x}H_xO)_y,$$

worin R und x jeweils die oben dafür angegebene Bedeutung haben, mit Dicarbonsäureanhydrid der Formel

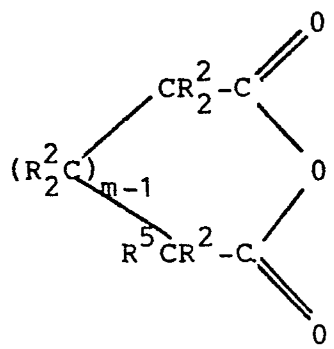

(I),

wobei $R^2$ und m jeweils die oben dafür angegebene Bedeutung haben und $R^5$ ein einwertiger, gegebenenfalls halogenierter Kohlenwasserstoffrest mit einer aliphatischen Kohlenstoff-Kohlenstoff-Doppelbindung ist, in für die Anlagerung von aliphatischer Kohlenstoff-Kohlenstoff-Doppelbindung an Si-gebundenen Wasserstoff an sich bekannter Weise umgesetzt wird und dann in einer zweiten Stufe die Anhydridgruppen der in der 1. Stufe erhaltenen Verbindung mit einer Verbindung der Formel

$$(H_2C{=}CR^2Y_x)_aR^3XH, \qquad (II)$$

worin $R^2$, $R^3$, X, Y, a und x jeweils die oben dafür angegebene Bedeutung haben, in für die Umsetzung von Carbonsäureanhydridgruppen mit Zerevitinoff-aktiven Wasserstoff aufweisender Verbindung an sich bekannter Weise umgesetzt werden.

Beispiele für Reste $R^5$, welche die Reste $R^1$ ergeben, sind solche der Formel

$$-CH{=}CH_2,\ -CH_2CH{=}CH_2,\ -CH_2C(CH_3){=}CH_2$$

und o-, p- und m-$CH_2{=}CHC_6H_4$-, wobei der Arylrest halogeniert sein kann.

Bevorzugt wird in der 1. Stufe mit dem Si-gebundenen Wasserstoff enthaltenden Organopolysiloxan Allylbernsteinsäureanhydrid umgesetzt.

Vorzugsweise wird Verbindung der Formel (I) in Mengen von 1 bis 1,2 Mol je Grammatom Si-gebundenen Wasserstoffs eingesetzt.

Vorzugsweise wird die 1. Stufe in Gegenwart eines die Anlagerung von aliphatischer Kohlenstoff-Kohlenstoff-Doppelbindung an Si-gebundenen Wasserstoff fördernden Katalysators, wie $H_2PtCl_6 \cdot 6H_2O$, durchgeführt.

Als Verbindung der Formel

$$(H_2C{=}CR^2Y_x)_aR^3XH$$

ist Hydroxyethylacrylat besonders bevorzugt. Weitere Beispiele für Verbindungen der Formel

$$(H_2C{=}CR^2Y_x)_aR^3XH$$

sind Allylalkohol, 1-Penten-5-ol, Pentaerytrittrimethacrylat,Trimethylolpropandimethacrylat,Hydroxyethylacrylamid, Hydroxyethylacrylsäurethioester, Allylamin, Allylthiol, Thiopentaerytrittriacrylthiolat, Aminopentaerytrittriacrylamid, 2-Thioethylallylsulfid und 2-Hydroxyethylallylsulfid.

Vorzugsweise wird Verbindung der Formel (II) in Mengen von 1 bis 1,2 Mol je Mol Verbindung der Formel (I) eingesetzt.

Das erfindungsgemäße Verfahren kann in einem gegenüber den Reaktionsteilnehmern und Katalysator inertem Lösungsmittel, wie Toluol, Tetrahydrofuran oder Dioxan und in ein und demselben Gefäß ohne vorhergehende Reinigung des in der 1. Stufe erhaltenen Produkts durchgeführt werden.

Das erfindungsgemäße Verfahren wird vorzugsweise beim Druck der umgebenden Atmosphäre, also bei 1020 hPa (abs.) oder etwa 1020 hPa (abs.), und 80 bis 120°C durchgeführt. Gegebenenfalls können aber auch höhere oder niedrigere Drücke und höhere oder niedrigere Temperaturen angewandt werden.

Vorzugsweise wird aus dem Endprodukt das Lösungsmittel bei erniedrigtem Druck abdestilliert.

Die Organopolysiloxane der Formel

$$A_xR_{3-x}SiO(SiR_{2-x}A_xO)_nSiR_{3-x}A_x$$

oder

$$(SiR_{2-x}A_xO)_y$$

können mit anderen Organopolysiloxanen, insbesondere solchen der Formel

$$HOR_2Si(SiR_2O)_nSiR_2OH$$

oder

$$(R_2SiO)_y,$$

worin R, n und y jeweils die oben dafür angegebene Bedeutung haben, in an sich bekannter Weise äquilibriert werden.

Vorzugsweise werden die erfindungsgemäßen oder erfindungsgemäß hergestellten Organopolysiloxane durch Ultraviolett-Licht vernetzt, wobei solches mit Wellenlängen im Bereich von 200 bis 400 nm (Nanometer) bevorzugt ist. Das Ultraviolett-Licht kann z.B. in Xenon-, Quecksilbernieder-, Quecksilbermitt l- oder Quecksilberhochdrucklampen erzeugt werden. Zur Vernetzung durch Licht ist auch solches mit einer Wellenlänge von 400 bis 600 nm, also sogenanntes "Halogenlicht", geeignet. Werden die erfindungsgemäßen oder erfindungsgemäß hergestellten Organopolysiloxane durch Licht vernetzt, so müssen diese Organopolysiloxane im Gemisch mit mindestens einem Photosensibilisator vorliegen. Beispiele für Photosensibilisatoren sind Anthrachinon und substituierte Anthrachinone, wie Chloranthrachinone, Benzophenon und substituierte Benzophenone, wie Hydroxybenzophenone, Xanthon und substituierte Xanthone, Acetophenone und substituierte Acetophenone, Benzoin und substituierte Benzoine, wie Benzoinether, Thioxanthon und substituierte Thioxanthone, Benzil und substituierte Benzile, wie Benzilketale, Fluorenon und substituierte Fluorenone. Zusätzlich zu den bereits erwähnten einzelnen Beispielen für Photosensibilisatoren seien als weitere einzelne Beispiele für Photosensibilisatoren benannt: 2-Hydroxy-2-methyl-1-phenylpropan-1-on, 2,4-Bis-(trimethylsiloxy)-benzophenon, Trichlorbutylacetophenon, Mesityloxyd, Propiophenon, Benzaldehyd, Fluoren, Carbazol, 3-Methylacetophenon, 4-Methylacetophenon, 3-Bromacetophenon, 4-Methylbenzophenon, 4-Chlorbenzophenon, 4,4'-Dimethoxybenzophenon, 4-Chlor-4'-benzylbenzophenon, 3-Chlorxanthon, 3,9-Dichlorxanthon, 3-Chlor-8-nonylxanthon, Michler's Keton, Zimtsäure, Benzoinmethylether, Anthrachinon-1,5-disulfonsäure-dinatriumsalz und 2-Naphtalinsulfonylchlorid.

Wenn die erfindungsgemäßen oder erfindungsgemäß hergestellten Organopolysiloxane im Gemisch mit Photosensibilisator vorliegen, so beträgt die Menge an Photosensibilisator vorzugsweise 0,5 bis 2 Gewichtsprozent, bezogen auf das Gewicht dieser Organopolysiloxane.

Weil die erfindungsgemäßen oder erfindungsgemäß hergestellten Organopolysiloxane vorzugsweise durch Ultraviolett-Licht vernetzt werden, sind Gegenstand der Erfindung auch Organo-

polysiloxane der Formel

$$A_xR_{3-x}SiO(SiR_{2-x}A_xO)_nSiR_{3-x}A_x$$

oder

$$(SiR_{2-x}A_xO)_y,$$

worin A, R, n, x und y jeweils die oben dafür angegebene Bedeutung haben, im Gemisch mit Photosensibilisator.

Die erfindungsgemäßen oder erfindungsgemäß hergestellten Organopolysiloxane können aber auch durch andere energiereiche Strahlung als die oben genannten Lichtarten vernetzt werden, nämlich durch Röntgen-, Gamma- oder Elektronenstrahlen. Bei derartiger anderer Strahlung sind 1 bis 4 mRad ausreichend.

Ebenso können die erfindungsgemäßen oder erfindungsgemäß hergestellten Organopolysiloxane mittels Radikalbildnern, wie Peroxyden, in der Wärme vernetzt werden. Werden als Radikalbildner dabei Peroxyde verwendet, so sind Peroxyd-Mengen von 0,1 bis 5 Gewichtsprozent, bezogen auf das Gewicht der Organopolysiloxane, bevorzugt. Als Temperaturen, bei denen die Vernetzung mit Radikalbildnern durchgeführt wird, sind 80° bis 200°C bevorzugt. Beispiele für Peroxyde sind Dicumylperoxyd, Benzoylperoxyd, Bis-(2,4-dichlorbenzoyl)-peroxyd und Organosiliciumgruppen enthaltende Peroxyde.

Gegenstand der Erfindung ist schließlich auch die Verwendung der erfindungsgemäßen oder erfindungsgemäß hergestellten Organopolysiloxane zur Herstellung von Überzügen oder zum Einbetten von elektronischen Bauteilen.

Die Oberflächen, auf welche die erfindungsgemäßen oder erfindungsgemäß hergestellten Überzüge aufgebracht werden können, können sein, z.B. diejenigen von keramischen Gegenständen oder Glas, einschließlich Glasfasern, wozu wiederum Lichtleitfasen gehören, Papieren, wie Kraftpapier oder Pergaminpapier, Pappen, einschließlich solcher aus Asbest, weiterhin Zellglas, Holz, Kork, Kunststoffolien, z. B. Polyethylenfolien oder Polypropylenfolien, von gewebtem oder ungewebtem Tuch aus natürlichen oder synthetischen organischen Fasern und von Metallen, wie Stahl oder Aluminium.

Das Auftragen der erfindungsgemäßen oder erfindungsgemäß hergestellten Organopolysiloxane auf die zu überziehenden Oberflächen kann in beliebiger, für die Herstellung von Überzügen aus flüssigen Stoffen geeigneter und vielfach bekannter Weise erfolgen, beispielsweise durch Tauchen, Streichen, Gießen, Sprühen, Aufwalzen, Drucken, z.B. mittels einer Offsetgravurüberzugsvorrichtung, Messer- oder Rakelbeschichtung.

Bei dem Auftragen der erfindungsgemäßen oder erfindungsgemäß hergestellten Organopolysiloxane auf die zu überziehenden Oberflächen können die Organopolysiloxane gegebenenfalls in Lösungsmittel oder in Form einer wäßrigen Emulsion vorliegen. Vorzugsweise sind jedoch bei diesem Auftragen keine Lösungsmittel vorhanden.

Beispiele für elektronische Bauteile, die in erfindungsgemäße oder erfindungsgemäß hergestellte Organopolysiloxane eingebettet werden können, sind Hybridschaltkreise, z. B. für elektronische Zündungen, Module, photovoltaische Solargeneratoren und andere Halbleiteranordnungen.

Selbstverständlich werden die erfindungsgemäßen und erfindungsgemäß hergestellten Organopolysiloxane auch bei ihrer Verwendung zur Herstellung von Überzügen oder zum Einbetten von elektronischen Bauteilen vorzugsweise durch Ultraviolett-Licht vernetzt.

Die Überzüge aus den erfindungsgemäßen und erfindungsgemäß hergestellten Organopolysiloxanen eignen sich z. B. als Grundierungen und als Schmutz und Wasser abweisende Überzüge. Außer zur Herstellung von Überzügen oder zum Einbetten elektronischen Bauteilen eignen sich die erfindungsgemäßen und erfindungsgemäß hergestellten Organopolysiloxane ganz allgemein als Gießharze, weiterhin als Klebstoffe, als Zusätze zu anderen Stoffen zur Verbesserung der Haftung dieser anderen Stoffe auf Unterlagen und als Verfestigungs- oder Bindemittel für kleinteilige, feste Stoffe, wie Sand oder Holzmehl.

In den folgenden Beispielen beziehen sich alle Angaben von Prozentsätzen auf das Gewicht.

<u>Beispiel 1</u>

146,6 g eines in den endständigen Einheiten je ein Si-gebundenes Wasserstoffatom aufweisenden Dimethylpolysiloxans

mit durchschnittlich 23 Siliciumatomen je Molekül im Gemisch mit $H_2PtCl_6 \cdot 6H_2O$ werden auf 90°C erwärmt. Zu diesem erwärmten Gemisch werden unter Rühren tropfenweise 28 g Allylbernsteinsäureanhydrid in 50 g Toluol gegeben. Das $H_2PtCl_6 \cdot 6H_2O$ wurde dem Dimethylpolysiloxan in solcher Menge zugesetzt, daß die Menge an Platin, berechnet als Element, 50 Gewichts-ppm (= Teile je Million), bezogen auf das Gesamtgewicht von Dimethylpolysiloxan und Säureanhydrid, beträgt. Nach Beendigung der Zugabe des Säureanhydrids wird noch 1 Stunde bei 90°C gerührt.

Zu der so erhaltenen Flüssigkeit werden bei 90°C unter Rühren tropfenweise 22,6 g 2-Hydroxyethylacrylat gegeben. Nach Beendigung der Zugabe des Acrylats wird die Mischung auf 100°C erwärmt und 2 Stunden bei dieser Temperatur gerührt. Dann werden die bei 0,1 hPa (abs.)bis zu 100°C siedenden Stoffe abdestilliert.

Aufgrund der $^1H$-NMR-Analyse sind die Si-gebundenen Wasserstoffatome des zunächst eingesetzten Organopolysiloxans alle durch den Rest der Formel

$$H_2C{=}CHCOO(CH_2)_2OOCCH_2CH(COOH)(CH_2)_3-$$

oder

$$H_2C{=}CHCOO(CH_2)_2OOC\underset{\substack{|\\ CH_2(CH_2)_2-}}{C}HCH_2COOH$$

ersetzt.

Beispiel 2

Proben des gemäß Beispiel 1 hergestellten Organopolysiloxans mit Carboxyl- und Acryloxygruppen werden, nachdem sie mit 2 %, bezogen auf ihr Gewicht, 2-Hydroxy-2-methyl-1-phenyl-propan-1-on vermischt wurden, in verschiedenen Schichtdicken von 1 bis 12 mm auf kleine Platten aus Aluminium, Stahl, Porzellan, Holz und Polyethylen sowie auf Papier aufgestrichen und mit einer Quecksilber-Mitteldruck-Ultraviolett-Lampe mit einer Leistung von 80 Watt/cm Leuchtlänge und einem Maximum der Leistung bei 366 nm in einem Abstand von 10 cm belichtet. Je nach Schichtdicke werden nach 1 bis 8 Sekunden Belichtungszeit trockene Überzüge mit guter Haftung auf den Unterlagen, auf denen sie erzeugt wurden, erhalten.

Beispiel 3

286 g eines in den endständigen Einheiten je eine Si-gebundene Hydroxylgruppe aufweisenden Dimethylpolysiloxans mit einer Viskosität von etwa 100 mPa.s bei 25°C werden mit 12,9 g des gemäß Beispiel 1 hergestellten Organopolysiloxans mit Carboxyl- und Acryloxygruppen und 60 g Toluol sowie 200 Gewichts-ppm des Phosphornitridchlorids der Formel

$$Cl_3PNPCl_2NPCl_3.PCl_6$$

vermischt und 1,5 Stunden auf 100°C erwärmt. Die so erhaltene Mischung wird mit 0,1 ml einer 25 %-igen Lösung von 1,3-Divinyl-1,1,3,3-tetramethyldisilazan in Methylenchlorid vermischt, um den

Äquilibrierungskatalysator unwirksam zu machen. Nach Filtration werden die bei 0,1 hPa (abs.) bis zu 80°C siedenden Bestandteile der Mischung abdestilliert. Es wird ein klares Öl mit einer Viskosität von 13 000 mPa.s bei 25°C erhalten.

Beispiel 4

Die in Beispiel 2 beschriebene Arbeitsweise wird wiederholt mit der Abänderung, daß an Stelle des dort verwendeten Organopolysiloxans das gemäß Beispiel 3 hergestellte Öl mit einer Viskosität von 13 000 mPa.s bei 25°C eingesetzt wird. Es werden trockene, elastische Überzüge mit guter Haftung auf den Unterlagen, auf denen sie erzeugt wurden, nach 1 bis 8 Sekunden Belichtungszeit je nach Schichtdicke erhalten.

Beispiel 5

Die in Beispiel 1 beschriebene Arbeitsweise wird wiederholt mit den Abänderungen, daß an Stelle der 146,6 g des in Beispiel 1 verwendeten Organopolysiloxans 786g des Organopolysiloxans der Formel

$$(CH_3)_3SiO\left[Si(CH_3)_2O\right]_{100}\left[Si(CH_3)HO\right]_5Si(CH_3)_3 \quad ,$$

70 g Allylbernsteinsäureanhydrid anstelle der 28 g Allvlbernsteinsäureanhydrid und 58 g 2-Hydroxyethylacrylat anstelle der 22,6 g dieses Esters verwendet werden.
Ebenso wie bei Beispiel 1 sind dann aufgrund der $^1$H-NMR-Analyse alle Si-gebundenen Wasserstoffatome des zunächst

eingesetzten Organopolysiloxans durch die gleichen organischen Reste mit Carboxyl- und Acryloxygruppen, deren Formeln in Beispiel 1 angegeben sind, ersetzt.

Beispiel 6

Die in Beispiel 2 beschriebene Arbeitsweise wird wiederholt mit der Abänderung, daß an Stelle des dort verwendeten Organopolysiloxans das gemäß Beispiel 5 hergestellte Organopolysiloxan mit Carboxyl- und Acryloxygruppen verwendet wird. Je nach Schichtdicke werden nach 1 bis 8 Sekunden Beschichtungszeit trockene harte Überzüge mit guter Haftung auf den Unterlagen, auf denen sie erzeugt wurden, erhalten.

Patentansprüche

1. Vernetzbare Organopolysiloxane der Formel

$$A_xR_{3-x}SiO(SiR_{2-x}A_xO)_nSiR_{3-x}A_x$$

oder

$$(SiR_{2-x}A_xO)_y,$$

worin R gleiche oder verschiedene, einwertige, gegebenenfalls halogenierte Kohlenwasserstoffreste oder aus Kohlenstoff-, Wasserstoff-, Ethersauerstoff- und Fluoratom(en) aufgebaute, einwertige, aliphatische Reste, A gleiche oder verschiedene, SiC-gebundene organische Reste mit einer Carboxylgruppe und einer Carbonylgruppe, an die ein organischer Rest mit mindestens einer endständigen Kohlenstoff-Kohlenstoff-Doppelbindung gebunden ist, n eine ganze Zahl im Wert von mindestens 1, x 0 oder 1 und y eine ganze Zahl im Wert von 3 bis 10 bedeutet, wobei diese Organopolysiloxane mindestens einen Rest A je Molekül enthalten.

2. Organopolysiloxane nach Anspruch 1, dadurch gekennzeichnet, daß A ein Rest der Formel

$$(H_2C{=}CR^2Y_x)_aR^3X\overset{O}{\overset{\|}{C}}(CR^2_2)_nCR^2(COOH)R^1-$$

oder

$$(H_2C{=}CR^2Y_x)_yR^3X\overset{O}{\overset{\|}{C}}\underset{\underset{R^1-}{|}}{C}R^2(CR^2_2)_{m-1}COOH,$$

worin $R^1$ gleiche oder verschiedene zweiwertige, gegebenenfalls halogenierte Kohlenwasserstoffreste, $R^2$ Wasserstoff oder einwertige, von aliphatischen Kohlenstoff-Kohlenstoff-Mehrfachbindungen freie Kohlenwasserstoffreste mit 1 bis 10 Kohlenstoffatomen je Rest, $R^3$ einen Kohlenwasserstoffrest, der zweiwertig ist, wenn a den Wert 1 hat, dreiwertig ist, wenn a den Wert 2 hat, und vierwertig, wenn a den Wert 3 hat, X Sauerstoff, Schwefel oder einen Rest der Formel

$$-NR^2-,$$

wobei $R^2$ die oben dafür angegebene Bedeutung hat, und Y eine Gruppierung der Formel

$$-R^1O-$$

$$-\overset{O}{\overset{\|}{C}}O-$$

$$-R^1NR^2-$$

$$-\overset{O}{\overset{\|}{C}}NR^2-$$

$$-\overset{O}{\overset{\|}{C}}S-$$

$$-SR^1-,$$

worin $R^1$ und $R^2$ jeweils die oben dafür angegebene Bedeutung haben, a 1, 2 oder 3 und m eine ganze Zahl im Wert von 1 bis 6 ist und x die oben dafür angegebene Bedeutung hat, ist.

3. Organopolysiloxane nach Anspruch 1, dadurch gekennzeichnet, daß A ein Rest der Formel

$H_2C{=}CHCOO(CH_2)_2OOC(CH_2)_2CH(COOH)(CH_2)_3$-

oder

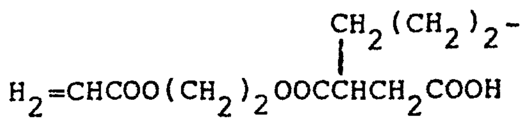

ist.

4. Verfahren zur Herstellung der Organopolysiloxane nach Anspruch 1 bis 3, d a d u r c h g e k e n n z e i c h n e t , daß zunächst in einer ersten Stufe Organopolysiloxan der Formel

$$H_xR_{3-x}SiO(SiR_{2-x}H_xO)_nSiR_{3-x}H_x$$

oder

$$(SiR_{2-x}H_xO)_y,$$

worin R und x jeweils die oben dafür angegebene Bedeutung haben, mit Dicarbonsäureanhydrid der Formel

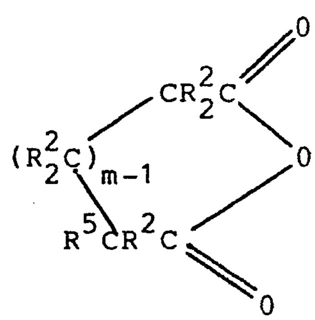

,

wobei $R^2$ und m jeweils die oben dafür angegebene Bedeutung

haben und $R^5$ ein einwertiger, gegebenenfalls halogenierter Kohlenwasserstoffrest mit einer aliphatischen Kohlenstoff-Kohlenstoff-Doppelbindung ist, in für die Anlagerung von aliphatischer Kohlenstoff-Kohlenstoff-Doppelbindung an Si-gebundenen Wasserstoff an sich bekannter Weise umgesetzt wird

und dann in einer zweiten Stufe die Anhydridgruppen der in der 1. Stufe erhaltenen Verbindung mit einer Verbindung der Formel

$$(H_2C{=}CR^2Y_x)_aR^3XH, \qquad (II)$$

worin $R^2$, $R^3$, X, Y, a und x jeweils die oben dafür angegebene Bedeutung haben, in für die Umsetzung von Carbonsäureanhydridgruppen mit Zerevitinoff-aktiven Wasserstoff aufweisender Verbindung an sich bekannter Weise umgesetzt werden.

5. Verfahren nach Anspruch 4, dadurch gekennzeichnet, daß als Verbindung der Formel (II) Allylbernsteinsäureanhydrid eingesetzt wird.

6. Organopolysiloxane nach mindestens einem der Ansprüche 1 bis 3, dadurch gekennzeichnet, daß sie sich im Gemisch mit Photosensibilisator befinden.

7. Verwendung der Organopolysiloxane nach mindestens einem der Ansprüche 1 bis 3 oder der nach Anspruch 4 oder 5 hergestellten Organopolysiloxane oder der Organopolysiloxane nach Anspruch 6 zur Herstellung von Überzügen oder zum Einbetten von elektronischen Bauteilen.

Patentansprüche für AT

1. Verfahren zur Herstellung von Organopolysiloxanen, dadurch gekennzeichnet, daß zunächst in einer ersten Stufe Organopolysiloxan der Formel

$$H_xR_{3-x}SiO(SiR_{2-x}H_xO)_nSiR_{3-x}H_x$$

oder

$$(SiR_{2-x}H_xO)_y,$$

worin R gleiche oder verschiedene, einwertige, gegebenenfalls halogenierte Kohlenwasserstoffreste oder aus Kohlenstoff-, Wasserstoff-, Ethersauerstoff- und Fluoratom(en) aufgebaute, einwertige, aliphatische Reste bedeutet, n eine ganze Zahl im Wert von mindestens 1, x 0 oder 1 und y eine ganze Zahl im Wert von 3 bis 10 bedeutet, mit Dicarbonsäureanhydrid der Formel

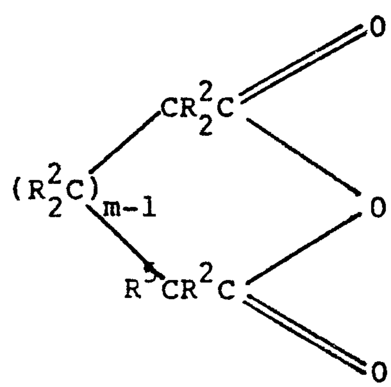

,

wobei $R^2$ Wasserstoff oder einwertige, von aliphatischen Kohlenstoff-Kohlenstoff-Mehrfachbindungen freie Kohlenwasserstoffreste mit 1 bis 10 Kohlenstoffatomen je Rest, $R^5$ einen einwertigen, gegebenenfalls halogenierten Kohlenwasserstoffrest mit einer aliphatischen Kohlenstoff-Kohlenstoff-Doppelbindung und m eine

ganze Zahl im Wert von 1 bis 6 bedeuten, in für die Anlagerung von aliphatischer Kohlenstoff-Kohlenstoff-Doppelbindung an Si-gebundenen Wasserstoff an sich bekannter Weise umgesetzt wird und dann in einer zweiten Stufe die Anhydridgruppen der in der 1. Stufe erhaltenen Verbindung mit einer Verbindung der Formel

$$(H_2C{=}CR^2Y_x)_aR^3XH, \qquad (II)$$

worin $R^2$ und x jeweils die oben dafür angegebene Bedeutung haben, a 1, 2 oder 3, $R^3$ einen Kohlenwasserstoffrest, der zweiwertig ist, wenn a den Wert 1 hat, dreiwertig ist, wenn a den Wert 2 hat, und vierwertig, wenn a den Wert 3 hat, X Sauerstoff, Schwefel oder einen Rest der Formel

$$-NR^2-,$$

worin $R^2$ die oben dafür angegebene Bedeutung hat, und Y eine Gruppierung der Formel

$$-R^1O-$$

$$-\overset{O}{\overset{\|}{C}}O-$$

$$-R^1NR^2-$$

$$-\overset{O}{\overset{\|}{C}}NR^2-$$

$$-\overset{O}{\overset{\|}{C}}S-$$

$$-SR^1-,$$

worin $R^2$ die oben dafür angegebene Bedeutung hat, und $R^1$ gleiche oder verschiedene zweiwertige, gegebenenfalls halogenierte Kohlenwasserstoffreste, bedeutet, in für die Umsetzung von Carbonsäureanhydridgruppen mit Zerevitinoff-aktiven Wasserstoff aufweisender Verbindung an sich bekannter Weise umgesetzt werden.

2. Verfahren nach Anspruch 1, dadurch gekennzeichnet, daß als Verbindung der Formel (II) Allylbernsteinsäureanhydrid eingesetzt wird.

3. Gemische aus nach Anspruch 1 oder 2 hergestellten Organopolysiloxanen und Photosensibilisator.

4. Verwendung der nach Anspruch 1 oder 2 hergestellten Organopolysiloxane oder der Gemische nach Anspruch 3 zur Herstellung von Überzügen oder zum Einbetten von elektronischen Bauteilen.